# EUROPEAN PATENT SPECIFICATION

(11) **EP 4 048 731 B1**
(45) Date of publication and mention of the grant of the patent: **02.08.2023**
(21) Application number: 20790261.0
(22) Date of filing: 12.10.2020
(51) Int. Cl.: C08L 25/12, C08L 55/02, C08L 51/04, C08K 5/09, C08K 5/20, C23C 18/16

(54) **POLYMERIC COMPOSITION FOR USE IN ELECTROLESS PLATING, METHOD OF ELECROLESS PLATING, AND POLYMERIC ARTICLE MADE BY ELECTROLESS PLATING**
POLYMERZUSAMMENSETZUNG ZUR VERWENDUNG BEI DER STROMLOSEN PLATTIERUNG, VERFAHREN ZUR STROMLOSEN PLATTIERUNG UND DURCH STROMLOSE PLATTIERUNG HERGESTELLTER POLYMERARTIKEL
COMPOSITION POLYMÈRE POUR UNE UTILISATION DANS UN PLACAGE ÉLECTROLYTIQUE, PROCÉDÉ DE PLACAGE ÉLECTROLYTIQUE ET ARTICLE FABRIQUÉ À PARTIR DE POLYMÈRES PAR PLACAGE ÉLECTROLYTIQUE

(30) Priority: 21.10.2019 EP 19204286
(43) Date of publication of application: 31.08.2022
(73) Proprietor: SABIC Global Technologies B.V., 4612 PX Bergen op Zoom (NL)
(72) Inventor: WAN, Chen, 6160 GA Geleen (NL); TAYLOR, Stephen, 6160 GA Geleen (NL); ZHOU, Bing, 6160 GA Geleen (NL); ESHENAUR, Jeffrey, 6160 GA Geleen (NL); GALLUCCI, Robert, Russell, 6160 GA Geleen (NL); XU, Jianhua, 6160 GA Geleen (NL)
(74) Representative: Sabic Intellectual Property Group
(86) International application number: PCT/EP2020/078567
(87) International publication number: WO 2021/078556

(56) References cited:
- CN-A- 105 713 336
- CN-A- 107 266 850
- US-A1- 2017 313 870

## Description

### BACKGROUND

Metal plating of plastic articles is used in various fields. For example, in the electronics field electroless plating has been used for forming conductive plated through holes in printed circuit boards. As a further example, in the automotive industry chrome plating of polymeric parts is used for making various car parts. In certain applications, the articles made are subject to wide ranges of temperatures during use during which the coating must retain good adhesion to the substrate. For example, when metal plated polymeric automotive parts may be exposed to temperatures well below 0 °C and well above 90 °C.

A challenge faced in current electroless plating is obtaining articles where there is adequate adhesion between the metal plating and the polymeric substrate even after repeated severe temperature cycling. Further, another challenge faced in current electroless plating is providing a composition which allows for reasonably broad process windows for forming articles (e.g. by injection molding) and subsequent electroless plating (which is typically followed by electrolytic plating - i.e. electroplating - of additional metal layers) while providing good properties in the final article. Examples of potentially important properties of the article include one or more of: impact strength, tensile strength, tensile modulus, flexural modulus, in the final article, coefficient of thermal expansion, uniform highly reflective appearance, and good adhesion between the metal coating and the polymeric substrate.

### BRIEF DESCRIPTION

Disclosed herein is a composition for electroless plating comprising: 9 to 29 weight percent, preferably 9.7 to 29 weight percent, more preferably10 to 29 weight percent, of a first graft rubber copolymer having a backbone, the backbone comprising at least one conjugated diene monomer in polymerized form, and, grafted to the backbone, a polymerized form of at least one monomer selected from monovinyl aromatic monomers, acrylic monomers, and combinations thereof; 70 to 90 weight percent, preferably 70-89.7 weight percent, more preferably 70 to 85 weight percent, of a styrenic polymer which is not grafter to a polymerized conjugated diene rubber; 0.1 to 10 weight percent of a core-shell diene based 0.1 to 10 weight percent of a core/shell diene-based rubber having particle size of 100 to 500 nanometers (nm), one or more of a stabilizer and/or antioxidant in total amount of from 0.1 to 5 weight percent, a fatty acid or a salt of fatty acid in an amount of from 0.1 to 2 weight percent, 0 to 5 weight percent of a mold release agent, 0 to 1 weight percent of a metal oxide, 0 to 3 weight percent of a lubricant, and 0 to 20 weight percent of polycarbonate wherein weight percent and ppm are based on total weight of the composition. Alternatively, the amounts of components expressed above can be parts by weight.

Also disclosed is an article comprising the composition. The article can have a metal coating electroless plated on the composition.

Also disclosed is a method of making such an article comprising forming the composition into a desired shape and electroless plating one or more metals onto the formed composition. The electroless plating process can comprise an etching step using an oxidizing acid. The electroless plating step can be followed by electroplating (e.g. electrolytic plating) of one or more additional metal layers.

### DETAILED DESCRIPTION

While acrylonitrile/butadiene/styrene graft rubber (ABS) compositions can be electroless plated, there remains a need for compositions that display one or more of the following characteristics alone or in combination: good adhesion with metal coating electroless and electrolytic plated thereon (particularly after thermal cycling), broad processing windows for forming articles from the composition (e.g. by injection molding), broad processing window for subsequent electroless plating of such articles to provide articles with no or few defects in the metal coating, and good mechanical properties such as impact strength, tensile strength, tensile modulus, flexural modulus, in the final article. The coefficient of thermal expansion can be such that the composition can be useful in electroless plated articles.
CN105713336A discloses a composition comprising ABS, SAN, toughener, polarity modifier, and processing aid.

Various compositions have been proposed. For example, WO 2013/1145903 provides examples of electroplated compositions comprising polycarbonate (PC), at least a primary ABS impact modifier and a second impact modifier chemically different from the primary impact modifier. WO2013/115903 discloses that when poly(styrene acrylonitrile) (SAN) is also included in the composition with the PC and two impact modifiers which are not both ABS are used, adhesion values for the plated sample decrease compared to compositions comprising a single ABS modifier. In addition, WO2013/115903 shows that adding methacrylate butadiene styrene (MBS) as a second impact modifier to a composition of ABS and PC reduces the adhesion values for the plated sample at lower polycarbonate contents. Surprisingly, in view of the teachings of WO2013/116903 regarding formulations with reduced adhesion, the compositions disclosed herein comprising 9 to 29 weight percent, preferably 9.7 to 29 weight percent, more preferably 10 to 29 weight percent, of a graft rubber of at least one conjugated diene monomer and at least one monovinyl aromatic monomer, from 70 to 90 weight percent, preferably 70-89.7 weight percent, more preferably 70 to 85 weight percent, of ungrafted styrenic polymer, from 0.1 to 10 weight percent of core/shell diene-based rubber having particle size of 100 to 500 nm, and fatty acid or salt of fatty acid in an amount of from 0.1 to 2 weight percent show better adhesion (including after thermal cycling) as compared to a similar composition excluding the core/shell butadienebased rubber. The total amount of conjugated diene rubber in the composition (e.g. the backbone of the first graft rubber copolymer and the diene-rubber core of the core/shell diene based rubber) can be 10 to 20 weight percent based on total weight of the composition. Alternatively, the amounts of components expressed above can be parts by weight.

### The First Graft Rubber Copolymer

Graft rubber copolymers, such as ABS, contain two or more polymeric parts of different compositions, which are bonded chemically. Such graft rubber copolymer can be prepared by first polymerizing a conjugated diene, such as butadiene or another conjugated diene, optionally with a monomer copolymerizable therewith, such as styrene, to provide a polymeric backbone. After formation of the polymeric backbone, at least one grafting monomer, and preferably two, are polymerized in the presence of the polymer backbone to obtain the graft copolymer. These resins can be prepared by methods well known in the art, for example emulsion or suspension radical polymerization.

The polymeric backbone is preferably a conjugated diene polymer such as polybutadiene, polyisoprene, or a copolymer, such as butadiene-styrene, butadiene-acrylonitrile, or the like.

The conjugated diene monomers normally utilized in preparing the polymeric backbone of the graft copolymer can be described by the following formula (I): 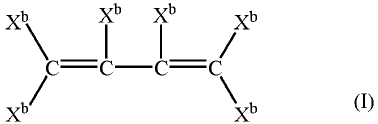 wherein X^{b} is hydrogen, C₁-C₅ alkyl, chlorine, bromine, or the like. Examples of conjugated diene monomers that may be used are butadiene, isoprene, 1,3-heptadiene, methyl-1,3-pentadiene, 2,3-dimethyl-1,3-butadiene, 2-ethyl-1,3-pentadiene; 1,3- and 2,4-hexadienes, chloro and bromo substituted butadienes such as dichlorobutadiene, bromobutadiene, dibromobutadiene, mixtures comprising at least one of the foregoing conjugated diene monomers, and the like. A preferred conjugated diene monomer is butadiene.

One monomer or group of monomers that may be polymerized in the presence of the polymeric backbone are monovinylaromatic hydrocarbons. The monovinylaromatic monomers utilized can be described by the following formula (II): 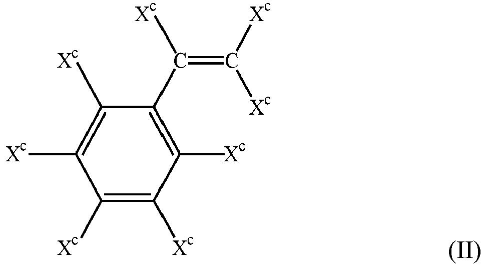 wherein X^{c} is hydrogen, C₁-C₁₂ alkyl (including cycloalkyl), C₆-C₁₂ aryl, C₇-C₁₂ aralkyl, C₇-C₁₂ alkaryl, C₁-C₁₂ alkoxy, C₆-C₁₂ aryloxy, chlorine, bromine, or the like. Examples of the monovinylaromatic monomers include styrene, 3-methylstyrene, 3,5-diethylstyrene, 4-n-propylstyrene, alpha-methylstyrene, alpha-methyl vinyltoluene, alpha-chlorostyrene, alphabromostyrene, dichlorostyrene, dibromostyrene, tetra-chlorostyrene, mixtures comprising at least one of the foregoing compounds, and the like. A preferred monovinyl aromatic monomer is styrene.

A second group of monomers that may be polymerized in the presence of the polymeric backbone are acrylic monomers such as acrylonitrile or substituted acrylonitrile.

The acrylonitrile, substituted acrylonitrile, can be described by the following formula (III): 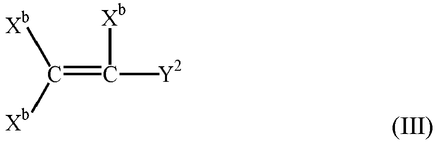 wherein X^{b} is as previously defined and Y² is cyano, or the like. Examples of such monomers include acrylonitrile, ethacrylonitrile, methacrylonitrile, alpha-chloroacrylonitrile, beta-chloroacrylonitrile, alpha-bromoacrylonitrile, beta-bromoacrylonitrile, mixtures comprising at least one of the foregoing monomers, and the like. A preferred monomer is acrylonitrile.

In the preparation of the graft copolymer, the polymeric backbone (e.g. derived from conjugated diene monomers and optional monovinyl aromatic comonomers and/or acrylic comonomers) can comprise at least 15 weight percent or at least 20 weight percent up to 65 weight percent or up to 60 weight percent or up to 50 weight percent of the total weight of the graft copolymer composition. For example, the graft copolymer composition can comprise 15 to 65 weight percent, or 15 to 60 weight percent or 15 to 50 weight percent, or 20 to 65 weight percent, or 20 to 60 weight percent or 20 to 50 weight percent of polymer backbone derived from conjugated diene monomers based on total weight of the graft copolymer composition. The monomers polymerized in the presence of the polymeric backbone, exemplified by styrene and acrylonitrile, can comprise from 35 weight percent or from 40 weight percent or from 50 weight percent up to 85 weight percent or to 80 weight percent based on total weight of the total graft polymer composition. For example, the graft copolymer composition can comprise 35 to 85 weight percent or 40 to 90 weight percent of one or more comonomers selected from monovinyl aromatic monomers and acrylic monomers. The acrylic monomers, exemplified by acrylonitrile, of the graft polymer composition, can comprises 5% to 40% by weight of the total graft copolymer composition. The monovinyl aromatic hydrocarbon, exemplified by styrene, can comprise 10 to 70% by weight of the total graft copolymer.

However, in preparing the graft copolymer composition, it is normal to have a certain percentage of the polymerizing monomers that are grafted on the polymeric backbone combine with each other and occur as free copolymer. For example, if styrene is utilized as one of the grafting monomers and acrylonitrile as the second grafting monomer, a certain portion of the composition will copolymerize as free, i.e. ungrafted, styrene-acrylonitrile copolymer. In the case where alpha-methylstyrene (or other monomer) is substituted for the styrene in the composition used in preparing the graft polymer, a certain percentage of the composition may be an alpha-methylstyrene-acrylonitrile copolymer. Thus, the grafted copolymer itself (not including the free polymer or copolymer of monomers polymerized in the presence of the backbone) can comprise from 55 or from 60 up to 80 or up to 75 or up to 70 weight percent of backbone comprising a polymerized form of a conjugated diene monomer and from 20 or from 25 up to 50 or up to 45 or up to 40 weight percent of polymerizing monomers in polymerized form grafted to the backbone. For example, the graft copolymer can comprise 55 to 75 weight percent or 60 to 70 weight percent backbone derived from a conjugated diene monomer and 25 to 45 weight percent or 30 to 40 weight percent of copolymer of one or more monomers of formula II and/or III grafted on the backbone.

The first rubber graft copolymer composition can be an acrylonitrile/butadiene/styrene. The ABS copolymer composition can comprise 20-65 weight percent butadiene based content (i.e. derived from butadiene monomers) based on total weight of the ABS copolymer. The weight ratio of styrene based content (i.e. derived from styrene) to acrylonitrile based content (i.e. derived from acrylonitrile) can be at least 65:35. The weight ratio of styrene based content to acrylonitrile based content can be no more than 80:20. However, for the graft copolymer itself (excluding free polystyrene, free acrylonitrile or free styrene acrylonitrile that is not grafted to the butadiene based backbone), the weight percent of butadiene based content can be from 55 or from 60 up to 80 or up to 75 or up to 70 weight percent of the graft copolymer and the grafted styrene acrylonitrile can be from 20 or from 25 or from 30 weight percent up to 45 or 40 weight percent based on total weight of the graft copolymer. The graft portion, (i.e. the styrene acrylonitrile grafted to the butadiene derived backbone) can be 40-60 weight percent or 45 to 55 weight percent based on weight of the backbone.

The first rubber graft copolymer can have particle size of at least 50 nanometers or at least 100 nanometers. The first rubber graft copolymer can have particle size up to 1000 nanometers or 800 nanometers. Particle size can be measured by light scattering UV-Vis spectroscopy, Scanning electron microscopy (SEM), Transmission electron microscopy (TEM) etc. The average particle size can be determined according to ASTM D1417 (2010). The first rubber graft copolymer can have gel content of at least 10%. The first rubber graft copolymer can have gel content up to 50%. Gel content can be measured by D2765-16 using tetrahydrofuran (THF) or acetone as solvent. The first rubber graft copolymer can be an ABS as described herein having the particle size and/or gel content as described herein.

The amount of the first rubber graft copolymer can be at least 9 weight percent, preferably at least 9.7 weight percent, more preferably at least 10 weight percent, even more preferably at least 15 weight percent and up to 29 or 25 weight percent based on total weight of the composition. The amount of the first rubber graft copolymer composition (including ungrafted polymer of the monomers which are grafted to the backbone) can be from 10 up to 59 weight percent or up to 55 weight percent or up to 50 weight percent based on total weight of the composition. For example, the composition can be made using a first rubber graft copolymer composition, exemplified by ABS (including free, ungrafted, SAN), in amounts of 10 to 59 weight percent or 20 to 55 weight percent, or 30 to 55 weight percent, or 35 to 50 weight percent based on total weight of the composition.

### Core/shell diene-based rubber

The composition further comprises a core-shell diene based rubber. The core-shell diene based rubber differs from the first rubber graft copolymer in its chemical composition, its morphology or both.

The core of the core shell diene based rubber comprises a polymer or copolymer of a conjugated diene monomer, such as in formula (I). For example, the core may comprise polybutadiene, polyisoprene, or a copolymer, such as butadiene-styrene, butadiene-acrylonitrile, or the like. According to a preferred embodiment the core is polybutadiene. The core can be at least 70 weight percent or at least 80 weight percent of the core/shell diene based rubber based on total weight of the rubber. The core can be up to 95 weight percent or up to 90 weight percent of the core/shell diene based rubber based on total weight of the rubber. For example, the core/shell diene based rubber can comprises a core, as exemplified by polybutadiene, in amounts of 70 to 95 weight percent or 80 to 95 weight percent or 75 to 90 weight percent based on total weight of the core/shell diene based rubber.

The shell is grafted to the core. The shell can comprise the polymerized form of one or more of vinyl aromatic monomers according to formula (II) and/or one or more acrylic monomers as shown in formula (IV): 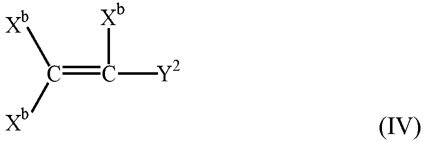 wherein X^{b} is as previously defined and Y² is cyano, C₁-C₁₂ alkoxycarbonyl, or the like. Examples of such monomers include acrylonitrile, ethacrylonitrile, methacrylonitrile, alpha-chloroacrylonitrile, beta-chloroacrylonitrile, alpha-bromoacrylonitrile, beta-bromoacrylonitrile, methyl acrylate, methyl methacrylate, ethyl acrylate, butyl acrylate, propyl acrylate, isopropyl acrylate, mixtures comprising at least one of the foregoing monomers, and the like.

Examples of such acrylic monomers include as acrylonitrile, substituted acrylonitrile and/or acrylic acid esters, exemplified by acrylonitrile, and C₁-C₇ alkyl acrylates, such as methyl methacrylate, and the like. An acrylate, such as methyl methacrylate is preferred.

The core/shell diene-based rubber can comprise at least 5 weight percent or at least 10 weight percent content based on one or more acrylic monomers. The core/shell diene-based rubber can comprise up to 29 or 20 weight percent content based on one or more acrylic monomers based on total weight of the rubber. The core/shell diene-based rubber can comprises at least 0.1 weight percent or at least 0.5 weight percent or at least 1 weight percent or at least 2 weight percent content based on one or more monovinyl aromatic monomers based on total weight of the core/shell diene-based rubber. The core/shell diene-based rubber can comprises up to 10 weight percent or up to 5 weight percent content based on one or more monovinyl aromatic monomers based on total weight of the rubber. For example, the core/shell diene-based rubber can comprises 5 to 29 weight percent or 5 to 20 weight percent acrylic monomer, exemplified by methyl methacrylate, and 0.1 to 10 weight percent monovinylaromatic monomer, exemplified by styrene, based on total weight of the core/shell diene-based rubber.

Preferably, the core/shell diene-based rubber is methyl methacrylate/butadiene/styrene (MBS). The core/shell MBS rubber can comprises at least 70 weight percent or at least 80 weight percent of polybutadiene core based on total weight of the MBS. The core/shell MBS rubber can comprise up to 95 weight percent or up to 90 weight percent of polybutadiene core based on total weight of the MBS. The amount of methyl methacrylate based content can be at least 5 weight percent or at least 10 weight percent based on total weight of the MBS. The amount of methyl methacrylate based content can be up to 29 weight percent or up to 20 weight percent based on total weight of the MBS. The amount of monovinyl aromatic (e.g. styrene) based content can be at least 0.1 weight percent or at least 0.5 weight percent or at least 1 weight percent or at least 2 weight percent based on total weight of the MBS. The amount of monovinyl aromatic based content can be up to 10 weight percent or up to 5 weight percent based on total weight of the MBS. For example, the core/shell diene-based rubber can comprise 70 to 95 weight percent polybutadiene core, 5 to 20 weight percent methyl methacrylate based content as part of a shell and 0.1 to 5 weight percent styrene based content based on total weight of the MBS.

The core/shell diene-based rubber is characterized by a relatively small particle size of the core-shell particles. The core/shell diene-based rubber particles can have an average size of at least 100 nanometers (nm). The core/shell diene-based rubber particles can have an average size up to 500 nm or up to 400 nm or up to 300 nm. For example, the particles can have an average size of 100 to 500 nm or 100 to 400 nm. Particle size can be measured by light scattering according to ASTM B822-17.

Inclusion of the small core/shell diene-based rubber in addition to the first graft rubber copolymer is believed to facilitate one or more of: modification or control of rheology of the composition during processing (e.g. injection molding), pore size control during etching as part of the electroless plating process, impact strength (especially at low temperature), and resistance to cracking.

The amount of the core/shell diene-based rubber is at least 0.1 weight percent or at least 0.5 weight percent or at least 1 weight percent or at least 2 weight percent or at least 3 weight percent based on total weight of the composition. The amount of core/shell diene based rubber is up to 10 weight percent or up to 9 weight percent or up to 8 weight percent or up to 7 weight percent or up to 6 weight percent or up to 5 weight percent based on total weight of the composition. For example, the composition can comprise the core/shell diene-based rubber in amounts of 0.1 to 10 weight percent, or 0.5 to 9 weight percent, or 1 to 8 weight percent, or 1 to 7 weight percent, or 2 to 6 weight percent or 3 to 5 weight percent based on total weight of the composition. Too much of the small particle size core shell rubber present in the formulation at the expense of the larger particle ABS graft rubber may lead to non-optimal etching and non-optimal pore size distribution with reduced metal plating adhesion.

### Ungrafted Styrenic Polymers and Copolymers

While the first graft rubber composition can include some free styrenic polymer residual from the process of making the first graft rubber composition, the compositions disclosed herein have a styrenic polymer present in amounts of 70 to 90 weight percent, preferably 70-89.7 weight percent, more preferably 70 to 85 weight percent based on total weight of the composition. Thus, some ungrafted styrenic polymer is added to the first graft rubber composition and the small particle size core shell rubber.

The terms "styrenic polymer" (which is inclusive of styrenic copolymer), as used herein, include polymers prepared by methods known in the art including bulk, suspension, and emulsion polymerization employing one or more monovinyl aromatic hydrocarbons of formula (II). The styrenic copolymers may be random, or block copolymers. Examples of monovinylaromatic monomers include styrene, 3-methylstyrene, 3,5-diethylstyrene, 4-n-propylstyrene, alpha-methylstyrene, alpha-methyl vinyltoluene, alpha-chlorostyrene, alpha-bromostyrene, dichlorostyrene, dibromostyrene, tetra-chlorostyrene, mixtures comprising at least one of the foregoing compounds, and the like. A preferred monovinyl aromatic monomer is styrene.

These polymers can contain a comonomer, such as vinyl monomers, acrylic monomers (including methacrylic monomers), maleic anhydride and derivatives, and the like, and combinations thereof. As defined herein, vinyl monomers are aliphatic compounds having one or at least one polymerizable carbon-carbon double bond. Suitable vinyl monomers include, for example, ethylene, propylene, butenes (including 1-butene, 2-butene, and isobutene), pentenes, hexenes, and the like; and combinations thereof.

Acrylic monomers include, for example, acrylonitrile, ethacrylonitrile, methacrylonitrile, α-chloroarylonitrile, β-chloroacrylonitrile, α-bromoacrylonitrile, and β-bromoacrylonitrile, methyl acrylate, methyl methacrylate, ethyl acrylate, butyl acrylate, propylacrylate, isopropyl acrylate, and the like, and mixtures thereof. Acrylonitrile nitrile monomer can give improved solvent resistance in many instances.

Maleic anhydride and derivatives thereof include, for example, maleic anhydride, maleimide, N-alkyl maleimide, N-aryl maleimide or the alkyl- or halo- substituted N-arylmaleimides, and the like, and combinations thereof. Acrylonitrile is a preferred comonomer.

The amount of comonomer(s) present in the styrenic copolymer can vary. The copolymer can comprise at least 50 weight percent or at least 60 weight percent or at least 65 weight percent content derived from monovinyl aromatic monomer (e.g., the amount of polymerized styrene monomers). The copolymer can comprise up to 90 weight percent or up to 85 weight percent or up to 80 weight percent content derived from monovinyl aromatic monomers such as styrene. The copolymer can comprise at least 10 weight percent or at least 15 weight percent or at least 20 weight percent up to 40 weight percent or up to 50 weight percent or up to 35 weight percent of content derived the comonomers specified above, (e.g. substituted or unsubstituted acrylonitrile). The weight percents of the monomers or monomer derived content are based on total weight of the styrenic copolymer. For example, the styrenic polymer can comprises 50 to 90 percent content of polymerized monovinyl aromatic monomer, exemplified by styrene, and 10 to 50 weight percent polymerized comonomer, exemplified by acrylonitrile, based on total weight of the styrenic polymer.

One preferred polystyrene copolymer resin is poly(styrene acrylonitrile), i.e. SAN. The SAN can have a weight average molecular weight as measured by gel permeation chromatography (GPC) by ASTM D5296-11 using a polystyrene standard of 50,000 to 160,000 g/mol.

The amount of ungrafted, styrenic polymer in the composition (including any amount of ungrafted sytrenic polymer which is provided as part of the first graft rubber copolymer composition) is 70 to 90 weight percent, preferably 70-89.7 weight percent, more preferably 70 to 85 weight percent, based on total weight of the composition. If the first graft rubber copolymer composition and/or the core-shell have high rubber content (e.g. high content of rubber backbone for first graft rubber copolymer), more free styrenic can be added to arrive at a total rubber content in the composition in the range 10 to 20 weight percent based on total weight of the composition.

### Fatty acid or fatty acid salt

The compositions further comprises one or more fatty acids or salts of fatty acids. The fatty acids are organic acids having from 8 to 40 carbon atoms. The salts are salts of such acids. Thus, the fatty acid can have the formula R-COOH and the salt may have the formula R-COOM, where R is a hydrocarbon having at least 8 or at least carbon atoms up to 40 or up to 36 or up to 30 or up to 24 or up to 20 carbon atoms and M is a metal ion. R may be a saturated or unsaturated hydrocarbon and may be linear or branched, but is frequently linear. R can be an alkyl. R can be alkenyl. If the number of carbon atoms is too low the fatty acid may be too volatile. If the number of carbon atoms is too high the fatty acid may not be sufficiently compatible in the polymer composition. Mixtures of fatty acids can be used. Examples of suitable fatty acids and their salts include myristic acid, linoleic acid, palmitic acid, oleic stearic, elaidic acid, stearic acid and their salts and any combination thereof.

Fatty acid salts of alkaline metals are preferred. Fatty acid salts of lead, mercury, thallium, cadmium, barium or antimony should be avoided due to potential toxicity and unfavorable environmental impact.

The fatty acid or fatty acid salt may assist in dispersion of the diene rubber particles in the composition and can also provide a metal release effect.

The total amount of all fatty acid and fatty acid salt is at least 1000 ppm or at least 2000 ppm or at least 3000 ppm based on total weight of the composition. The total amount of all fatty acid and fatty acid salt is no more than 20,000 ppm or no more than 15,000 ppm or no more than 10,000 ppm based on total weight of the composition. For example, the composition can comprise fatty acid and fatty acid salts in amounts of 1000 to 20,000 ppm, or 2000 to 15,000 ppm, or 3000 to 10,000 ppm based on total weight of the composition. If there is too much fatty acid there may be problems with juicing (or formation of liquid on the mold) in injection molding processes.

### Antioxidants and stabilizers

The disclosed compositions may further comprise one or more antioxidants. Examples of antioxidants include hindered phenol, secondary aryl amines, phosphorus-containing compounds such as phosphites or phosphonates, sulfur containing compounds such as thioesters or any combination thereof. More specific antioxidant additives include, for example, organic phosphites such as tris(nonyl phenyl)phosphite, tris(2,4-di-t-butylphenyl)phosphite, bis(2,4-di-t-butylphenyl)pentaerythritol diphosphite, distearyl pentaerythritol diphosphite or the like; alkylated monophenols or polyphenols; alkylated reaction products of polyphenols with dienes, such as tetrakis[methylene(3,5-di- tert-butyl-4-hydroxyhydrocinnamate)]methane, or the like; butylated reaction products of para-cresol or dicyclopentadiene; alkylated hydroquinones; hydroxylated thiodiphenyl ethers; alkylidene-bisphenols; benzyl compounds; esters of beta-(3,5-di-tert-butyl-4-hydroxyphenyl)- propionic acid with monohydric or polyhydric alcohols; esters of beta-(5-tert-butyl-4- hydro xy-3-methylphenyl)-propionic acid with monohydric or polyhydric alcohols; esters of thioalkyl or thioaryl compounds such as distearylthiopropionate, dilaurylthiopropionate, ditridecylthiodipropionate, octadecyl-3-(3,5- di-tert-butyl-4-hydroxyphenyl)propionate, pentaerythrityl-tetrakis[3-(3,5-di-tert-butyl-4-hydroxyphenyl)propionate or the like; amides of beta-(3,5-di-tert-butyl-4-hydroxyphenyl)-propionic acid or the like, or combinations comprising at least one of the foregoing antioxidants. Antioxidants, when used, can be included in amounts of at least 0.01 weight percent or at least 0.05 weight percent or at least 0.1 weight percent to 5 weight percent or to 3 weight percent or to 1 weight percent based on total weight of the composition. For example, the composition can comprise antioxidant in an amount of 0.01 to 5 weight percent, or 0.05 to 3 weight percent, or 0.1 to 1 weight percent based on total weight of the composition.

Suitable stabilizer additives include heat or light stabilizers.

Examples of heat stabilizers include organic phosphites such as triphenyl phosphite, tris-(2,6-dimethylphenyl)phosphite, tris-(mixed mono-and di- nonylphenyl)phosphite or the like; phosphonates such as dimethylbenzene phosphonate or the like, organic phosphates such as trimethyl phosphate, thioesters such as pentaerythritol betalaurylthiopropionate, and the like, or combinations comprising at least one of the foregoing heat stabilizers. Heat stabilizers when used, can be included in amounts of at least 0.01 weight percent or at least 0.05 weight percent or at least 0.1 weight percent up to 5 weight percent, or up to 3 weight percent, or up to 1 weight percent based on total weight of the composition. For example, the composition can comprise heat stabilizers in an amount of 0.01 to 5 weight percent, or 0.05 to 3 weight percent, or 0.1 to 1 weight percent based on total weight of the composition.

Although plated parts are usually protected from photoreaction light stabilizers and/or ultraviolet light (UV) absorbing additives may also be used, especially if the part is only partially plated. Suitable light stabilizer additives include, for example, benzotriazoles such as 2-(2- hydroxy-5-methylphenyl)benzotriazole, 2-(2-hydroxy-5 -tert-octylphenyl)-benzotriazole and 2-hydroxy-4-n-octoxy benzophenone, hindered amine light stabilizers (HALS), or the like, or combinations comprising at least one of the foregoing light stabilizers. Light stabilizers when used, can be included in amounts of at least 0.01, or at least 0.05, or at least 0.1 up to 10, or up to 5, or up to 3 weight percent based on total weight of the composition. For example, the composition can comprise light stabilizers in an amount of 0.01 to 5 weight percent, or 0.05 to 3 weight percent, or 0.1 to 1 weight percent based on total weight of the composition. Suitable UV absorbing additives include for example, hydroxybenzophenones; hydroxybenzotriazoles; hydroxybenzotriazines; cyanoacrylates; oxanilides; benzoxazinones; 2-(2H-benzotriazol-2-yl)-4-(1,1,3,3-tetramethylbutyl)-phenol (CYASORB^{™} 5411); 2- hydroxy-4-n-octyloxybenzophenone (CYASORB* 531); 2-[4,6- bis(2,4-dimethylphenyl)-1,3,5-triazin-2-yl]-5-(octyloxy)-phenol (CYASORB* 1164); 2,2*- (1,4-phenylene)bis(4H-3,1-benzoxazin-4-one) (CYASORB* UV-3638); 1,3-bis[(2-cyano- 3,3- diphenylacryloyl)oxy]-2,2-bis[[(2-cyano-3,3-diphenyl- acryloyl)oxy]methyl]propane (UVINUL* 3030); 2,2^{∗}-(1,4-phenylene)bis(4H-3,1-benzoxazin-4-one); 1,3-bis[(2-cyano-3,3-diphenylacryloyl)oxy]-2,2-bis[[(2-cyano-3,3-diphenyl-acryloyl)oxy]methyl]propane; or combinations comprising at least one of the foregoing UV absorbers. UV absorbers when used, can be included in amounts of at least 0.01 weight percent or at least 0.05 weight percent or at least 0.1 weight percent up to 5 weight percent or up to 3 weight percent or up to 1 weight percent based on total weight of the composition. For example, the composition can comprise UV absorbers in an amount of 0.01 to 5 weight percent, or 0.05 to 3 weight percent, or 0.1 to 1 weight percent based on total weight of the composition.

The total combined weight of antioxidant and/or stabilizers can be from 0.1 weight percent or from 0.2 weight percent to 5 weight percent or to 3 weight percent based on total weight of the composition. For example, the composition can comprise antioxidant and stabilizers it a combined amount of 0.1 to 3 weight percent. For example, the composition can comprise heat stabilizers in an amount of 0.01 to 5 weight percent, or 0.05 to 3 weight percent, or 0.1 to 1 weight percent based on total weight of the composition. For example, the composition can comprise antioxidizer in an amount of 0.01 to 5 weight percent, or 0.05 to 3 weight percent, or 0.1 to 1 weight percent based on total weight of the composition.

### Other Additives

The disclosed compositions can also optionally comprise one or more additives with the proviso that the additives do not adversely affect the desired properties of the compositions. Mixtures of additives may also be used. Such additives may be mixed at a suitable time during the mixing of the components for forming the composition.

Note that certain fillers, particularly inorganic fillers, such as talc, silica, TiO₂, clay, mica, nanofillers, glass fibers, glass flakes, glass spheres, are generally to be avoided as they can interfere with the etching phase of the composition during electroless plating. For example, loss of such inorganic particulate species from the composition during the etching process can lead to deposits in the etching baths reducing bath lifetime. Thus, the composition can be free of such fillers or such fillers are minimized and are present in amounts of less than 1000 ppm or less than 500 ppm or less than 200 or less than 100 ppm (i.e. parts per million by weight) based on total weight of the composition.

The composition may further comprise one or more mold release agents. Examples of suitable mold release agents include fatty acid esters, amides having long carbon chains, such as ethylene bis stearamide, or pentaerythritol tetra stearate, glycerol mono, di or tri stearate or polyolefins such as mineral oils, polyethylene, polypropylenes or combinations thereof. These materials can be used in total combined amounts of from 0 or from 0.1 weight percent to 5 weight percent or to 1 weight percent or to 0.5 weight percent based on total weight of the composition. For example, mold release agents can be present in amounts of 0.1 to 1 weight percent based on total weight of the composition.

The composition may further comprise one or more lubricants or plasticizers. There is considerable overlap among these types of materials, which include, for example, phthalic acid esters such as dioctyl-4,5-epoxy-hexahydrophthalate; tris(octoxycarbonylethyl)isocyanurate; tristearin; di- or polyfunctional aromatic phosphates such as resorcinol tetraphenyl diphosphate (RDP), the bis(diphenyl)phosphate of hydroquinone and the bis(diphenyl)phosphate of bisphenol-A; poly-alpha-olefins; epoxidized soybean oil; silicones, including silicone oils (e.g. having molecular weight of at least 1000 g/mol), such as polydimethylsiloxanes (PDMS); mixtures of methyl stearate and hydrophilic and hydrophobic nonionic surfactants comprising polyethylene glycol polymers, polypropylene glycol polymers, and copolymers thereof, e.g., methyl stearate and polyethylene-polypropylene glycol copolymers in a suitable solvent; waxes such as beeswax, montan wax, paraffin wax or the like. These materials can be used in amounts of from 0 or from 0.05 weight percent up to 5 weight percent or up to 1 weight percent or up to 0.1 weight percent based on total weight of the composition. For example, the amount of lubricant/plasticizer as exemplified by silicone oil, can be from 0 to 5 weight percent, or 0.1 to 1 weight percent based on total weight of the composition. Certain metal oxides can be used to help minimize juicing (i.e. deposition on the mold) of the fatty acids or their salts and certain other lubricants or plasticizers. Examples of such metal oxides include magnesium oxide (MgO), calcium oxide (CaO), and zinc oxide (ZnO). The metal oxide particles can have average particle size of 0.5 to 5 microns. Larger particle size, greater than 10 microns, in other instances greater than 25 microns can lead to undesirable pits and other blemishes in the plated parts. The metal oxide can have a chloride content of less than 1 weight percent based on total weight of the metal oxide. The metal oxide can be used in amounts of from 0 or from 0.1 weight percent up to 1 weight percent or up to 0.5 weight percent based on total weight of the composition; for example in ranges of 0.1 to 1 weight percent. The mole ratio of metal oxide to fatty acid can be at least 1:2 or at least 4:5 up to 5:1 or up to 2:1 or up to 1.5:1. For example, the range of mole ratio of metal oxide to fatty acid can be in the range of 1:2 to 5:1.

Certain colorants such as pigment and/or dye additives may also be present. Examples of pigments include for example, carbon black, certain metal oxides (provided they do not plate out or cause issues in forming the article or in electroless plating); sulfides such as zinc sulfides, or the like; aluminates; sodium sulfo-silicates sulfates, chromates, or the like; zinc ferrites; ultramarine blue; Pigment Brown 24; Pigment Red 101; Pigment Yellow 119; organic pigments such as azos, di-azos, quinacridones, perylenes, naphthalene tetracarboxylic acids, flavanthrones, isoindolinones, tetrachloroisoindolinones, anthraquinones, anthanthrones, dioxazines, phthalocyanines, and azo lakes; Pigment Blue 60, Pigment Red 122, Pigment Red 149, Pigment Red 177, Pigment Red 179, Pigment Red 202, Pigment Violet 29, Pigment Blue 15, Pigment Green 7, Pigment Yellow 147 and Pigment Yellow 150, or combinations comprising at least one of the foregoing pigments. Carbon black is one preferred pigment. The amount of pigment should not be so high as to cause problems in molding or etching. For example, the amount of pigment can be from 0, or from 0.01 up to 2, or up to 1 or up to 0.5 or up to 0.1 weight percent based on total weight of the composition. For example, carbon black can be used in amounts of 0.01 to 2, or 0.01 to 1, or 0.01 to 1 weight percent based on total weight of the composition.

The compositions disclosed herein can contain less than 20 or less than 10 or less than 5 or less than 3 or less than 1 weight percent of polycarbonate based on total weight of the composition. The compositions can be free of polycarbonate (i.e. contain no polycarbonate).

The composition disclosed herein can be characterized by a melt flow rate of at least 5, or at least 10 or at least 15 g/10 minutes at 10 kg and 220 °C according to ISO 1133:2011. The composition disclosed herein is characterized by a melt flow rate up to 40 or up to 35 or up to 30 g/10 minutes at 10 kg and 220 °C according to ISO1133.

The composition disclosed herein can be characterized by Izod Impact strength of at least 15 or at least 20 or at least 25 kJ/m² according to ISO 180:2011. The composition disclosed herein can be characterized by Izod Impact strength up to 50 or up to 40 kJ/m² according to ISO 180.

The composition disclosed herein can be characterized by a tensile modulus of at least 1500 or at least 2000 or at least 2200 MPa. The composition disclosed herein can be characterized by a tensile modulus of up to 4000 or up to 3500 MPa. The composition disclosed herein can be characterized by a tensile strength at yield of at least 35 or at least 40 MPa. The composition disclosed herein can be characterized by a tensile strength of up to 60 or up to 55 MPa. The composition disclosed herein can be characterized by an elongation at break of at least 10 or at least 20%. The composition disclosed herein can be characterized by an elongation at break of up to 200 or up to 150%. Tensile modulus, tensile strength at yield and elongation at break can be measured by ISO 527-2012 at 50 mm/minute.

The composition can be characterized by a coefficient of thermal expansion of at least 50 or at least 60 or at least 65 micrometers/m-°C. The composition can be characterized by a coefficient of thermal expansion of up to 90 micrometers/m-°C according to ASTM E831-14 (i.e. 2014).

The composition can be characterized by a heat distortion temperature (HDT) at 1.8 MPa force of at least 75°C according to ISO 75-2004.

The composition can be characterized by a Vicat C softening point of at least 90°C according to ISO 306:2004 at 50 °C/minute.

The composition can be characterized by a flexural modulus of 2000 to 4000 MPa as measured by ISO 178:2010.

### Manufacture of composition

The composition can be manufactured by methods generally available in the art. For example, in one embodiment, in one manner of proceeding, the components can be first blended, in a Henschel high speed mixer or other suitable mixer/blender. Other low shear processes including but not limited to hand mixing may also accomplish this blending. The blend can then be fed into the throat of a twin-screw extruder via a hopper. Alternatively, one or more of the components may be incorporated into the composition by feeding directly into the extruder at the throat and/or downstream through a sidestuffer. Such additives may also be compounded into a masterbatch with a desired polymeric resin and fed into the extruder. The extruder can be operated at a temperature higher than that necessary to cause the composition to flow. The extrudate can be immediately quenched (e.g. in a water bath) and pelletized. The pellets may be used for subsequent molding, shaping, or forming.

### Articles and their manufacture

The compositions can be formed into useful shaped articles by a variety of means such as, for example: injection molding, additive manufacturing, extrusion, rotational molding, compression molding, blow molding, sheet or film extrusion, profile extrusion, gas assist molding, structural foam molding and thermoforming. The thermoplastic compositions with improved electroplate adhesion described herein can also be made into film and sheet as well as components of laminate systems. The composition can be formed into articles by co-molding, over-molding or laminating with other thermoplastics such as polycarbonate, polystyrene blends, poly(meth)acrylates and the like.

The articles formed from the composition can be relatively thin, having for example thickness from 1 or from 2 or from 5 mm up to 20 or up to 15 mm. The articles can have an aspect ratio (length and/or weight to thickness) of at least 10.

The formed thermoplastic article can be plated with metal by known process such as electroless plating. For example, the surface to be plated can be surface treated. Surface treatment steps can include one or more of etching, neutralization, activation and acceleration. Etching can be done with strong oxidizing solutions such as chromium trioxide and sulfuric acid mixture to create a surface structure for good adhesion and/or convert a hydrophobic surface to hydrophilic surface. In this step the diene rubber may be selectively removed (etched) at and near the surface. The selective removal can form sockets on the surface to which the adhesion promoter can attach. After etching the surface can be rinsed with a neutralizing solution such as sodium bisulfite. Activating agents (or adhesion promoter) such as precious metals (e.g. palladium) in acid solution can produce a catalytic surface for effective plating. The activated surface can then be exposed to an electroless plating solution (e.g. in a bath) to plate out the metal on the catalytic surface. The plating solution can comprise a metal salt a reducer a complexing agent a stabilizer and a buffer. Additional metal layers can be applied by repeating electroplating a similar or distinct metal on the first deposited metal coating. Rinse steps, e.g. in chemical bath, can be used to minimize or avoid contamination of chemistry between surface treatment steps.

After etch, the adhesion promoter, such as a palladium can mechanically attach to the surface which is then conductive and can bond with metals such as nickel or copper during subsequent electroplating.

During the electroless coating, nickel and/or copper can be coated onto the substrate. During subsequent electroplating, additional metal layers comprising metals such as nickel, copper, chromium, cobalt, zinc or alloys thereof, can be added. There may be various layers for example, a nickel layer, a copper layer, a chromium layer. According to one preferred structure, there are the following layers in order starting at the polymeric composition: nickel, copper, nickel, chromium.

The thickness of any one metal layer may be at least 0.5 or at least 1 or at least 2 micrometers. The thickness of any one layer may be up to 50 or up to 40 or up to 30 or up to 25 micrometers. For example a single metal layer may have a thickness of 0.5 to 50 micrometers. The total thickness of the metal layers after electrolytic plating can be at least 2, at least 5 or at least 10 micrometers. The total thickness of the metal layers can be up to 150 or up to 120 or up to 100 micrometers. For example, the total thickness of the metal layers can be 2 to 150 micrometers. According to one example, the metal coating comprises 2 micrometers of nickel/20 micrometers of copper/10-20 micrometers of nickel/0.2-5 (or 0.2 to 1) micrometers of chromium.

A polymers seal layer may be applied over the top metal layer. Examples of such polymer seal layers include acrylic and/or epoxy coatings, polyurethane coating as well as silica containing hard coats.

The plated articles disclosed herein can have a peel strength according to ASTM B533-85 of at least 8 (1401 N/m) or at least 9 (1576 N/m) or at least 10 pounds force/inch (lbf/in) (1751 N/m). The plated articles disclosed herein can have a peel strength up to 20 lbf/in (3502 N/m).

The plated articles disclosed herein can display remarkable resistance to thermal cycling without visual sign of failure. Visual sign of failure can be defects such as delamination, bubbles, hazing, cracking or the like. The thermal cycling test involves the following steps:
1) inspecting sample for defects
2) placing defect free sample in a -40 °F (-40 °C) environment for one hour
3) removing from the cold environment and inspecting for defects,
4) within 2 minutes of removal from the cold environment, placing sample in a hot environment at 200 °F (93 °C) for one hour
5) removing from the hot environment and inspecting for defects,
6) within 2 minutes of removal from the hot environment placing sample in the cold environment at -40 °F for one hour,
7) repeating steps 3-6 until defects are detected.
The plated articles can withstand at least 7, at least 8, at least 9, or at least 10 cycles without defect.

The metal plated article can have a reflectivity as measured by ASTM C1503-08 of at least 99%.

The metal plated articles can be suitable for use in automotive or transportation applications in that they have good gravel chip resistance and good chemical resistance (e.g. pass road salt test exposure criteria).

The plated articles comprising the composition disclosed herein can be used in transportation (e.g. automotive), electronics or plumbing applications or devices. For example, transportation or automotive application the article can be or can be used in articles selected from instrument panels, overhead consoles, interior trim, center consoles, panels, quarter panels, rocker panels, trim, fenders, doors, deck lids, trunk lids, hoods, bonnets, roofs, bumpers, fascia, grilles, minor housings, pillar appliques, cladding, body side moldings, wheel covers, hubcaps, door handles, spoilers, window frames, headlamp bezels, headlamps, tail lamps, tail lamp housings, tail lamp bezels, license plate enclosures, roof racks, running boards, radio speaker grilles, instrument panel bezels, steering columns, drip rails, energy absorbers, kick panels, mirror housings, grille opening reinforcements, steps, hatch covers, knobs, buttons, and levers.

As another example the article can be or can be a component of, for example, computer and business machine housings, home appliances, trays, plates, handles, helmets, plumbing parts such as faucets, or shower heads. In various further examples, formed articles include, but are not limited to, power tools, food service items, medical devices, animal cages, electrical connectors, enclosures for electrical equipment, electric motor parts, power distribution equipment, communication equipment, computers and the like, including devices that have molded in snap fit connectors. Articles of the present invention can comprise exterior body panels and parts for outdoor or protected graphics such as signs, outdoor enclosures such as telecommunication and electrical connection boxes, and construction applications such as roof sections, wall panels and glazing.

### EXAMPLES

The following materials were used in the examples:
- Styrene/acrylonitrile (SAN) - 72 wt% styrene/28 wt% acrylonitrile weight average molecular weight, M_{w} of 150,000 g/mol, number average molecular weight, Mn, of 70,000 g/mol. Commercially available as Blendex^{™} 576 from Galata Chemicals.
- Acrylonitrile/butadiene/styrene (ABS) graft rubber composition - 21 part acrylonitrile, 31 parts butadiene, 46 parts styrene, 2 parts methyl methacrylate. The ABS rubber comprises an insoluble grafted rubber portion and an ungrafted rigid SAN portion Grafted SAN/rubber = 52 wt% of the graft rubber composition. Ungrafted (rigid extractable) SAN comprises 48 weight percent of the ABS graft rubber composition and has a weight average molecular weight (Mw) = 120,000 g/mol. and a number average molecular weight (Mn) = 35,000 g/mol. Mw and Mn determined by GPC using polystyrene standards. Rubber particle size is 300 nm, with a broad particle size distribution. The ABS graft rubber comprises 6300 ppm by weight of the ABS rubber of tallow fatty acid (TFA). TFA is a mixture of saturated and unsaturated carboxylic acids comprising myristic, linoleic, palmitic, oleic, elaidic and stearic acid.
- Methyl methacrylate/butadiene/styrene (MBS) Core Sell Rubber - 13 part methyl methacrylate/ 68 parts butadiene/17 parts styrene - 175 nm particle size. Commercially available as Paraloid EXL2961A from The Dow Chemical Co.
- Ethylene bis-stearamide, MW 539 g/mol, melting point (MP) 145 °C.
- Magnesium stearate, Mw 697 g/mol, MP 155 °C.
- Pentaerythritol diphosphite as a stabilizer, MW 605 g/mol. MP 175 °C. Commercially available as Ultranox 626 from Addivant Co.
- Hindered Phenol Antioxidant. Wingstay L from Omnova. MW 650 g/mo. MP 118 °C.
- Dimethylsiloxane polymer - 1000 centipoise viscosity (Momentive).
- Magnesium Oxide (MgO) 390 ppm. Particle size less than 1 micrometer. Surface area 160 to 200 square meters/gram, 99% of particles pass 325 mesh.
- Carbon black pigment grade, 0.035wt%.

The ingredients were combined in the amounts in parts by weight shown in Table 1 below in a paint shaker and then extruded into pellets at 180 to 250 °C on a co-rotating twin screw extruder at about 400 rpm with vacuum applied. Pellets of the compositions were evaluated for melt flow rate (MFR) at 220 °C. Test parts were injection molded on pellets dried for 2hrs at 95°C and molded at 220 to 250 °C with a 25 sec. cycle time. Izod impact, tensile modulus and strength (at yield), heat distortion temperature (HDT), coefficient of thermal expansion (CTE) were measured according to the test methods stated above and in Tables 2 and 3. Samples were conditioned for at least 2 days at 50%, relative humidity at 23°C prior to testing.

The articles are electroless plated substantially according to the following process with bath aeration and partial rinse primarily with water between each chemical bath:
- 10 minute soak clean in Trimax LSAC 349,
- chrome sulfuric acid etch for 10 minutes at 159 °F and pH <10,
- Adhemax Neutralizer CR to reduce hexavalent Chromium for 1 minute
- Pre-activation to maintain HCl concentration for 1 minute
- Adhemax Activator SF to form Pd nuclei on the plastic surface for 4 minutes
- Adhemax Accelerator to accelerate Pd adsorbtion for 2 minutes
- Adhemax EN to deposit electroless nickel for 10 minutes
- Copper Immersion to add electroless copper layer for 2 minutes
- Electrolytic copper strike to add 2-3 micrometer copper layer
- Standard electroplate process for additional metal layers.

Injection molded 3-dimensional sample plaques were then metallized as described above and tested for Thermal Shock according to the thermal cycling test set forth above. Injection molded flat sample plaques were metallized as described above. For the samples used for the thermal cycling test, the following metal layers were added by electroplating (i.e., electrolytically coated): 25-40 micrometer copper, semi-bright nickel (10-15 micrometer), bright nickel (8-15 micrometer), microporous nickel (0.5-3.0 micrometer), and chromium (0.25 micrometer). For adhesion testing, the electroplated (i.e., electrolytically coated) metal was a 40-80 micrometer copper layer. Adhesion was determined by Peel Strength test method ASTM B533-85. As seen in Table 2, Samples 1 and 2 including the MBS core shell rubber survive about 2 times as many (11 and 12 cycles) thermal shock cycles before failure as compared to Comparative Sample A, with only one type of rubber, that fails at 6 cycles.

**Table 1**

| **Examples** | A | 1 | 2 |
|---|---|---|---|
| Ungrafted SAN added (parts by weight ("pbw")) | 51.5 | 48.0 | 54.8 |
| ABS Graft Rubber Composition (pbw) | 48.5 | 48.5 | 40.2 |
| MBS Core Shell Rubber (pbw) | 0.0 | 3.5 | 5.0 |
| ETHYLENE BISSETEARAMIDE (pbw) | 1.0 | 1.0 | 1.0 |
| MAGNESIUM STEARATE(pbw) | 0.3 | 0.3 | 0.3 |
| PHOSPHITE STABILIZER(pbw) | 0.1 | 0.1 | 0.1 |
| HINDERED PHENOLNTIOXIDANT (pbw) | 0.1 | 0.1 | 0.1 |
| DIMETHYLSILOXANE POLYMER (pbw) | 0.2 | 0.2 | 0.2 |
| Carbon Black (pbw) | 0.0345 | 0.0345 | 0.0345 |
| Total Butadiene based rubber (wt% based on total weight of composition) | 15.5 | 18.0 | 16.0 |
| Total ABS graft copolymer (wt% based on total weight of composition) | 24.8 | 24.8 | 20.9 |
| Total Ungrafted SAN (weight percent based on total weight of composition) | 75.2 | 71.7 | 74.1 |

**Table 2**

| | A | 1 | 2 |
|---|---|---|---|
| **MFR** (cc/10 min) by ISO 1133 at 220°C, 10 kg, 300 x | 22.9 | 20.5 | 23.3 |
| **IZOD Impact** (kJ/m²) by ISO 180 | 27.7 | 32.0 | 26.4 |
| **Tensile Modulus** (MPa) by ISO 527 at 50 mm/min | 2413 | 2258 | 2434 |
| **Tensile Strength (Y)** (MPa) by ISO 527 | 44 | 42 | 49 |
| **HDT** (°C ) at 1.8 MPa by ISO 75 | 80 | 77 | 79 |
| **Vicat** (°C) by ISO 306 | 96 | 95 | 97 |
| CTE flow (µm/ (m-°C)) by ASTM E831-14 (in flow direction) | 76 | 77 | 69 |
| **CTE** cross flow (µm/ (m-°C)) by ASTM E831-14 (cross flow direction) | 86 | 88 | 75 |
| **Peel Strength** (lbf/inch) by ASTM B533 | 7 | 11 | 9 |
| **Thermal Shock cycles** | 6 | 11 | 12 |

The compositions, methods, and articles can alternatively comprise, consist of, or consist essentially of, any appropriate materials, steps, or components herein disclosed. The compositions, methods, and articles can additionally, or alternatively, be formulated so as to be devoid, or substantially free, of any materials (or species), steps, or components, that are otherwise not necessary to the achievement of the function or objectives of the compositions, methods, and articles.

All ranges disclosed herein are inclusive of the endpoints, and the endpoints are independently combinable with each other (e.g., ranges of "up to 25 wt.%, or, more specifically, 5 wt.% to 20 wt.%", is inclusive of the endpoints and all intermediate values of the ranges of "5 wt.% to 25 wt.%," etc.). Moreover, stated upper and lower limits can be combined to form ranges (e.g. "at least 1 or at least 2 weight percent" and "up to 10 or 5 weight percent" can be combined as the ranges "1 to 10 weight percent", or "1 to 5 weight percent" or "2 to 10 weight percent" or "2 to 5 weight percent"). "Combinations" is inclusive of blends, mixtures, alloys, reaction products, and the like. The terms "first," "second," and the like, do not denote any order, quantity, or importance, but rather are used to distinguish one element from another. The terms "a" and "an" and "the" do not denote a limitation of quantity and are to be construed to cover both the singular and the plural, unless otherwise indicated herein or clearly contradicted by context. "Or" means "and/or" unless clearly stated otherwise. Reference throughout the specification to "some embodiments", "an embodiment", and so forth, means that a particular element described in connection with the embodiment is included in at least one embodiment described herein, and may or may not be present in other embodiments. In addition, it is to be understood that the described elements may be combined in any suitable manner in the various embodiments. A "combination thereof' is open and includes any combination comprising at least one of the listed components or properties optionally together with a like or equivalent component or property not listed.

Unless specified to the contrary herein, all test standards are the most recent standard in effect as of the filing date of this application, or, if priority is claimed, the filing date of the earliest priority application in which the test standard appears.

Unless defined otherwise, technical and scientific terms used herein have the same meaning as is commonly understood by one of skill in the art to which this application belongs.

Compounds are described using standard nomenclature. For example, any position not substituted by any indicated group is understood to have its valency filled by a bond as indicated, or a hydrogen atom. A dash ("-") that is not between two letters or symbols is used to indicate a point of attachment for a substituent. For example, -CHO is attached through carbon of the carbonyl group.

The term "alkyl" means a branched or straight chain, unsaturated aliphatic hydrocarbon group, e.g., methyl, ethyl, n-propyl, i-propyl, n-butyl, s-butyl, t-butyl, n-pentyl, s-pentyl, and n- and s-hexyl. "Alkenyl" means a straight or branched chain, monovalent hydrocarbon group having at least one carbon-carbon double bond (e.g., ethenyl (-HC=CH₂)). "Alkoxy" means an alkyl group that is linked via an oxygen (i.e., alkyl-O-), for example methoxy, ethoxy, and sec-butyloxy groups. "Aryl" means an aromatic hydrocarbon group containing the specified number of carbon atoms, such as phenyl, tropone, indanyl, or naphthyl. "The prefix "halo" means a group or compound including one more of a fluoro, chloro, bromo, or iodo substituent. A combination of different halo groups (e.g., bromo and fluoro), or only chloro groups can be present. The prefix "hetero" means that the compound or group includes at least one ring member that is a heteroatom (e.g., 1, 2, or 3 heteroatom(s)), wherein the heteroatom(s) is each independently N, O, S, Si, or P. "Substituted" means that the compound or group is substituted with at least one (e.g., 1, 2, 3, or 4) substituents that can each independently be a C₁₋₉ alkoxy, a C₁₋₉ haloalkoxy, a nitro (-NO₂), a cyano (-CN), a C₁₋₆ alkyl sulfonyl (-S(=O)z-alkyl), a C₆₋₁₂ aryl sulfonyl (-S(=O)₂-aryl)a thiol (-SH), a thiocyano (-SCN), a tosyl (CH₃C₆H₄SO₂-), a C₃₋₁₂ cycloalkyl, a C₂₋₁₂ alkenyl, a C₅₋₁₂ cycloalkenyl, a C₆₋₁₂ aryl, a C₇₋₁₃ arylalkylene, a C₄₋₁₂ heterocycloalkyl, and a C₃₋₁₂ heteroaryl instead of hydrogen, provided that the substituted atom's normal valence is not exceeded. The number of carbon atoms indicated in a group is exclusive of any substituents. For example -CH₂CH₂CN is a C₂ alkyl group substituted with a nitrile.

## Claims

1. A composition for electroless plating comprising:
• 9 to 29 weight percent of a first graft rubber copolymer having a backbone, the backbone comprising at least one conjugated diene monomer in polymerized form, and, grafted to the backbone, a polymerized form of at least one monomer selected from monovinyl aromatic monomers, acrylic monomers, and combinations thereof, preferably wherein the first graft rubber copolymer comprises acrylonitrile/butadiene/styrene rubber,
• 70-90 weight percent of ungrafted styrenic polymer,
• 0.1 to 10 weight percent of a core/shell diene-based rubber having particle size of 100 to 500 nm,
• one or more of a stabilizer and/or antioxidant in total amount of 0.1 to 5 weight percent,
• fatty acid or salt of fatty acid in an amount of 0.1 to 2 weight percent,
• 0 to 5 weight percent of a mold release agent,
• 0 to 1 weight percent of a metal oxide,
• 0 to 3 weight percent of a lubricant,
• 0 to 20 weight percent of a polycarbonate,
wherein weight percent and ppm are based on total weight of the composition.

2. The composition of claim 1, wherein the first graft rubber copolymer comprises acrylonitrile/butadiene/styrene rubber and wherein the acrylonitrile/butadiene/styrene rubber comprises 55 to 75 weight percent of the backbone derived from butadiene monomer and 25 to 45 weight percent copolymer of styrene and acrylonitrile grafted on the backbone.

3. The composition of claim 1 or 2 wherein the ungrafted styrenic polymer comprises poly(styrene acrylonitrile) having 20-35 wt.% acrylonitrile derived content and 65-80% styrene derived content and a weight average molecular weight as measured by gel permeation chromatography by ASTM D5296 using a polystyrene standard of 50,000 to 160,000 g/mol.

4. The composition of any one of the preceding claims wherein the core-shell diene-based rubber has a core comprising a second polymerized conjugated diene monomer and a shell comprising polymerized product of at least one acrylate monomer and at least one monovinyl aromatic monomer.

5. The composition of claim 4 wherein the second conjugated diene monomer is butadiene, the acrylate monomer is methyl methacrylate, and the monovinyl aromatic monomer is styrene.

6. The composition of any one of the preceding claims wherein one or more of a stabilizer and/or antioxidant are selected from one or more of hindered phenols, phosphorous containing stabilizers, sulfur containing stabilizers, or combinations thereof.

7. The composition of any one of the preceding claims **characterized by** having less than 1000 ppm of any of the following materials: titanium dioxide, clay, talc, mica, lead stabilizers, cadmium stabilizer, nano fillers, glass.

8. The composition of any one of the preceding claims **characterized by** one or more of the following:
• a melt flow rate of 10 to 40 g/10 minutes at 10 kg and 220 °C according to ISO 1133,
• Izod impact or 20 to 50 KJ/square meter according to ISO 180,
• tensile modulus of 2000 to 4000 MPa according to ISO 527,
• % elongation at break: 10 - 200% according to ISO 527,
• coefficient of thermal expansion (CTE) from 70 to 90 um/(m-°C) by ASTM E831-14.

9. A composition according to any of the preceding claims comprising:
• 9 to 29 weight percent, preferably 9.7 to 29 weight percent, preferably 10 to 29 weight percent, of acrylonitrile/butadiene/styrene graft rubber composition,
• 70 to 90 weight percent, preferably 70 to 89.7 weight percent, more preferably 70 to 85 weight percent, of poly(styrene acrylonitrile),
• 0.1 to 10 weight percent of methyl methacrylate/butadiene/styrene core-shell rubber
• 0.1 to 5 weight percent of one or more of stabilizer and/or antioxidant,
• 1000 to 20,000 ppm of fatty acid or salt of fatty acid comprising 8 to 36 carbon atoms,
• 0 to 5 weight percent of a mold release agent and/or lubricant,
• 0 to 1 weight percent of magnesium oxide, zinc oxide, or calcium oxide,
• 0 to 3 weight percent of silicone oil,
• 0 to 5 weight percent of the polycarbonate,
wherein weight percent and ppm are based on total weight of the composition.

10. An article comprising the composition of any one of claims 1-9 formed into a shape having a surface wherein a metal coating is electroless plated on a portion of the surface.

11. The article of claim 10 **characterized by** one or more of the following:
• a metal layer peel strength of 1401 to 3502 N/m by ASTM B533-85,
• the article survives more than 6 cycles of being placed in a -40 °C environment for an hour and then being placed in a 93 °C environment for an one hour with no more than 2 minutes between the environments with no visible delamination, bubbles, cracking or defect of the metal coating.

12. The article of claim 10 or 11 wherein the metal coating comprises in order starting at the surface of the composition a nickel layer and a chromium layer.

13. The article of any one of claims 10-12 which is an automotive component.

14. A method for making the article of any one of claims 10-12 comprising forming the composition into a shape, etching the shape with an oxidizing acid and electroless plating one or more metals onto a portion of the formed and etched composition.

15. The method of claim 14 wherein the forming of the composition into a desired shape comprises injection molding.

## Patentansprüche

1. Zusammensetzung für Metallabscheidung ohne äußere Stromquelle, umfassend:
• 9 bis 29 Gew.-% eines ersten Pfropf-Kautschuk-Copolymer mit einem Rückgrat, wobei das Rückgrat wenigstens ein konjugiertes Dienmonomer in polymerisierter Form, und auf das Rückgrat gepfropft, eine polymerisierte Form wenigstens eines Monomers umfasst, ausgewählt aus aromatischen Monovinylmonomeren, Acrylmonomeren und Kombinationen davon, vorzugweise wobei der erste Pfropf-Kautschuk-Copolymer Acrylnitril/Butadien/Styrolkautschuk umfasst,
• 70-90 Gew.-% eines ungepfropften Styrolpolymers,
• 0,1 bis 10 Gew.-% eines Kern-/Hüllenkautschuks auf Dienbasis mit einer Partikelgröße von 100 bis 500 nm,
• ein oder mehrere eines Stabilisators und/oder eines Antioxidationsmittels in einer Gesamtmenge von 0,1 bis 5 Gew.-%,
• eine Fettsäure oder ein Salz einer Fettsäure in einer Menge von 0,1 bis 2 Gew.-%,
• 0 bis 5 Gew.-% eines Formtrennmittels,
• 0 bis 1 Gew.-% eines Metalloxids,
• 0 bis 3 Gew.-% eines Schmiermittels,
• 0 bis 20 Gew.-% eines Polycarbonats,
wobei Gew.-% und ppm auf dem Gesamtgewicht der Zusammensetzung basieren.

2. Zusammensetzung nach Anspruch 1, wobei das erste Pfropf-Kautschuk-Copolymer Acrylnitril/Butadien/Styrolkautschuk umfasst und wobei der Acrylnitril/Butadien/Styrolkautschuk 55 bis 75 Gew.-% des Rückgrats, das von einem Butadienmonomer abgeleitet ist, und 25 bis 45 Gew.-% eines Copolymers aus Styrol und Acrylnitril umfasst, das auf das Rückgrat gepfropft wurde.

3. Zusammensetzung nach Anspruch 1 oder 2, wobei das ungepfropfte Styrolpolymer Poly(styrolacrylnitril) mit 20-35 Gew.-% von Acrylnitril abgeleitetem Gehalt und 65-80 % von Styrol abgeleitetem Gehalt und ein gewichtsgemitteltes Molekulargewicht, wie durch Gelchromatographie durch ASTM D5296 unter Verwendung einer Polystyrolnorm gemessen, von 50.000 bis 160.000 g/mol umfasst.

4. Zusammensetzung nach einem der vorhergehenden Ansprüche, wobei der Kern-Hülle-Kautschuk auf Dienbasis einen Kern, der ein zweites polymerisiertes konjugiertes Dienmonomer umfasst, und eine Hülle aufweist, die ein polymerisiertes Produkt wenigstens eines Acrylatmonomers und wenigstens eines aromatischen Monovinylmonomers umfasst.

5. Zusammensetzung nach Anspruch 4, wobei das zweite konjugierte Dienmonomer Butadien ist, das Arcylatmonomer Methylmethacrylat ist und das aromatische Monovinylmonomer Styrol ist.

6. Zusammensetzung nach einem der vorhergehenden Ansprüche, wobei einer oder mehrere eines Stabilisators und/oder eines Antioxidationsmittel aus einem oder mehreren von gehemmten Phenolen, phosphorhaltigen Stabilisatoren, schwefelhaltigen Stabilisatoren oder Kombinationen davon ausgewählt sind.

7. Zusammensetzung nach einem der vorhergehenden Ansprüche, **gekennzeichnet durch** das Aufweisen von weniger als 1000 ppm eines der folgenden Materialien: Titandioxid, Ton, Talkum, Glimmer, Bleistabilisatoren, Kadmiumstabilisatoren, Nanofüllstoffen, Glas.

8. Zusammensetzung nach einem der vorhergehenden Ansprüche, **gekennzeichnet durch** eines oder mehrere der Folgenden:
• einer Schmelzflussrate von 10 bis 40 g/10 Minuten bei 10 kg und 220 °C gemäß ISO 1133,
• Izod-Schlagzähigkeit oder 20 bis 50 KJ/Quadratmeter gemäß ISO 180,
• Zugmodul von 2000 bis 4000 MPa gemäß ISO 527,
• % Reißdehnung: 10 - 200 % gemäß ISO 527,
• thermischer Ausdehnungskoeffizient (CTE) von 70 bis 90 um/(m-°C) durch ASTM E831-14.

9. Zusammensetzung nach einem der vorhergehenden Ansprüche, umfassend:
• 9 bis 29 Gew.-%, vorzugsweise 9,7 bis 29 Gew.-%, vorzugsweise 10 bis 29 Gew.-% einer Acrylnitril/Butadien/Styrol-Pfropf-Kautschukzusammensetzung,
• 70 bis 90 Gew.-%, vorzugsweise 70 bis 89,7 Gew.-%, stärker bevorzugt 70 bis 85 Gew.-% von Poly(styrolacrylnitril),
• 0,1 bis 10 Gew.-% eines Methylmethacrylat/Butadien/Styrol-Kem-Hülle-Kautschuks
• 0,1 bis 5 Gew.-% eines oder mehrerer Stabilisatoren und/oder Antioxidationsmittel,
• 1000 bis 20.000 ppm einer Fettsäure oder eines Salzes der Fettsäure, umfassend 8 bis 36 Kohlenstoffatome,
• 0 bis 5 Gew.-% eines Formtrennmittels und/oder eines Schmiermittels,
• 0 bis 1 Gew.-% Magnesiumoxid, Zinkoxid oder Kalziumoxid,
• 0 bis 3 Gew.-% eines Silikonöls,
• 0 bis 5 Gew.-% eines Polycarbonats,
wobei Gew.-% und ppm auf dem Gesamtgewicht der Zusammensetzung basieren.

10. Gegenstand, der die Zusammensetzung nach einem der Ansprüche 1-9 umfasst, die in eine Form mit einer Oberfläche ausgebildet ist, wobei eine Metallbeschichtung ohne äußere Stromquelle auf einen Abschnitt der Oberfläche abgeschieden wird.

11. Gegenstand nach Anspruch 10, **gekennzeichnet durch** eines oder mehrere der Folgenden:
• ein Metallschichthaftvermögen von 1401 bis 3502 N/m durch ASTM B533-85,
• der Gegenstand überlebt mehr als 6 Zyklen, in denen er für eine Stunde lang in eine Umgebung von -40 °C platziert wird und dann für eine Stunde lang in eine Umgebung von 93 °C platziert wird, mit nicht mehr als 2 Minuten zwischen den Umgebungen mit keinem sichtbaren Aufblättern, Blasen, Rissbildung oder Mangel der Metallschicht.

12. Gegenstand nach Anspruch 10 oder 11, wobei die Metallbeschichtung in der Reihenfolge beginnend an der Oberfläche der Zusammensetzung eine Nickelschicht und eine Chromschicht umfasst.

13. Gegenstand nach einem der Ansprüche 10-12, die ein Automobilbauteil ist.

14. Verfahren zum Herstellen des Gegenstands nach einem der Ansprüche 10-12, umfassend das Ausbilden der Zusammensetzung in eine Form, das Ätzen der Form mit einer Oxidierungssäure und Abscheiden ohne äußere Stromquelle eines oder mehrerer Metalle auf einen Abschnitt der ausgebildeten und geätzten Zusammensetzung.

15. Verfahren nach Anspruch 14, wobei das Ausbilden der Zusammensetzung in eine gewünschte Form Spritzgießen umfasst.

## Revendications

1. Composition pour placage autocatalytique comprenant :
• 9 à 29 % en poids d'un premier copolymère de caoutchouc greffé ayant un squelette, le squelette comprenant au moins un monomère de diène conjugué sous forme polymérisée, et, greffé au squelette, une forme polymérisée d'au moins un monomère choisi parmi les monomères aromatiques monovinyliques, les monomères acryliques et leurs combinaisons, préférablement dans lequel le premier copolymère de caoutchouc greffé comprend du caoutchouc acrylonitrile/butadiène/styrène,
• 70 à 90 % en poids de polymère styrénique non greffé,
• 0,1 à 10 % en poids d'un caoutchouc à base de diène coeur/enveloppe ayant une granulométrie de 100 à 500 nm,
• un ou plusieurs parmi un stabilisant et/ou un antioxydant en une quantité totale de 0,1 à 5 % en poids,
• acide gras ou sel d'acide gras en une quantité de 0,1 à 2 % en poids,
• 0 à 5 % en poids d'un agent de démoulage,
• 0 à 1 % en poids d'un oxyde métallique,
• 0 à 3 % en poids d'un lubrifiant,
• 0 à 20 % en poids d'un polycarbonate,
dans laquelle le pourcentage en poids et les ppm sont basés sur le poids total de la composition.

2. Composition selon la revendication 1, dans laquelle le premier copolymère de caoutchouc greffé comprend du caoutchouc acrylonitrile/butadiène/styrène et dans laquelle le caoutchouc acrylonitrile/butadiène/styrène comprend 55 à 75 % en poids du squelette dérivé du monomère butadiène et 25 à 45 % en poids de copolymère de styrène et d'acrylonitrile greffé sur le squelette.

3. Composition selon la revendication 1 ou 2, dans laquelle le polymère styrénique non greffé comprend du poly(styrène acrylonitrile) ayant une teneur dérivée d'acrylonitrile de 20 à 35 % en poids et une teneur dérivée de styrène de 65 à 80 % et un poids moléculaire moyen en poids tel que mesuré par chromatographie par perméation de gel selon ASTM D5296 utilisant une norme de polystyrène de 50000 à 160000 g/mol.

4. Composition selon l'une quelconque des revendications précédentes, dans laquelle le caoutchouc à base de diène coeur-enveloppe a un coeur comprenant un second monomère de diène conjugué polymérisé et une enveloppe comprenant un produit polymérisé d'au moins un monomère acrylate et d'au moins un monomère aromatique monovinylique.

5. Composition selon la revendication 4, dans laquelle le second monomère diène conjugué est le butadiène, le monomère acrylate est le méthacrylate de méthyle et le monomère aromatique monovinylique est le styrène.

6. Composition selon l'une quelconque des revendications précédentes, dans laquelle un ou plusieurs parmi un stabilisant et/ou un antioxydant sont choisis parmi un ou plusieurs parmi les phénols encombrés, les stabilisants contenant du phosphore, les stabilisants contenant du soufre ou leurs combinaisons.

7. Composition selon l'une quelconque des revendications précédentes, **caractérisée en ce qu'**elle contient moins de 1000 ppm de l'un quelconque des matériaux suivants : dioxyde de titane, l'argile, le talc, le mica, les stabilisants au plomb, un stabilisant au cadmium, les nanocharges, le verre.

8. Composition selon l'une quelconque des revendications précédentes, **caractérisée par** un ou plusieurs des éléments suivants :
• un indice de fluidité de 10 à 40 g/10 minutes à 10 kg et 220 °C selon ISO 1133,
• un impact Izod ou 20 à 50 KJ/mètre carré selon ISO 180,
• un module de traction de 2000 à 4000 MPa selon ISO 527,
• un % d'allongement à la rupture : 10 à 200% selon ISO 527,
• un coefficient de dilatation thermique (CTE) de 70 à 90 um/(m-°C) selon ASTM E831-14.

9. Composition selon l'une quelconque des revendications précédentes comprenant :
• 9 à 29 % en poids, préférablement 9.7 à 29 % en poids, préférablement 10 à 29 % en poids, d'une composition de caoutchouc greffé acrylonitrile/butadiène/styrène,
• 70 à 90 % en poids, préférablement 70 à 89,7 % en poids, plus préférablement 70 à 85 % en poids, de poly(styrène acrylonitrile),
• 0,1 à 10 % en poids de caoutchouc à base de méthacrylate de méthyle/butadiène/styrène coeur-enveloppe,
• 0,1 à 5 % en poids d'un ou plusieurs stabilisants et/ou antioxydants,
• 1000 à 20000 ppm d'acide gras ou de sel d'acide gras comprenant de 8 à 36 atomes de carbone,
• 0 à 5 % en poids d'un agent de démoulage et/ou d'un lubrifiant,
• 0 à 1 % en poids d'oxyde de magnésium, d'oxyde de zinc ou d'oxyde de calcium,
• 0 à 3 % en poids d'huile de silicone,
• 0 à 5 % en poids du polycarbonate,
dans laquelle le pourcentage en poids et les ppm sont basés sur le poids total de la composition.

10. Article comprenant la composition selon l'une quelconque des revendications 1 à 9, façonnée en une forme ayant une surface dans laquelle un revêtement métallique est plaqué de façon autocatalytique sur une partie de la surface.

11. Article selon la revendication 10, **caractérisé par** un ou plusieurs des éléments suivants :
• une résistance au pelage de la couche métallique de 1401 à 3502 N/m selon la norme ASTM B533-85,
• l'article survit à plus de 6 cycles d'être placé dans un environnement à -40 °C pendant une heure, puis d'être placé dans un environnement à 93 °C pendant une heure avec pas plus de 2 minutes entre les environnements sans délaminage visible, bulles, fissuration ou défaut du revêtement métallique.

12. Article selon la revendication 10 ou 11, dans lequel le revêtement métallique comprend dans l'ordre en partant de la surface de la composition une couche de nickel et une couche de chrome.

13. Article selon l'une quelconque des revendications 10 à 12, qui est un composant automobile.

14. Procédé de fabrication de l'article selon l'une quelconque des revendications 10 à 12 comprenant la mise en forme de la composition, la gravure de la forme avec un acide oxydant et le placage autocatalytique d'un ou plusieurs métaux sur une partie de la composition formée et gravée.

15. Procédé selon la revendication 14, dans lequel la formation de la composition en une forme souhaitée comprend le moulage par injection.
